# EUROPEAN PATENT APPLICATION

(11) **EP 1 901 595 A2**
(43) Date of publication of application: **19.03.2008**
(21) Application number: 07115556.8
(22) Date of filing: 03.09.2007
(51) Int. Cl.: H05K 5/00

(54) **Housing for portable computer device and method of making same**

(30) Priority: 12.09.2006 US 519027
(71) Applicant: SafeNet, Inc., Belcamp, MD 21017 (US)
(72) Inventor: Sterling, Brian Curtis, Jarrettsville, MD 21084 (US); Cetrone, John Robert, Clarkesville, MD 21029 (US)
(74) Representative: McIlroy, Steven David

(57) **Abstract**

A portable computer device, comprising a circuit board; a connector in communication with the circuit board, the connector adapted for insertion into a computer port; a light source associated with the circuit board; and a housing encasing at least the circuit board and the light source, the housing comprising a substantially opaque body portion and a substantially transparent or translucent lens portion, the lens portion located proximate the light source.

## Description

### BACKGROUND OF THE INVENTION

### Field of the Invention

The present invention relates generally to a housing for a portable computer device, such as a USB key, and more particularly, to a co-molded plastic housing for a portable computer device including one or more translucent or transparent portions.

### Related Art

Portable computer devices, such as USB keys, are known in the art. These types of devices can be plugged into a USB port or other computer port, and used for various functions. For example, USB keys can be used as data storage devices and/or security devices. Portable computer devices often include an opaque housing, typically formed of plastic, that covers all but the portion of the device that plugs into the computer port. The opaque housing is especially important when the device is a security device, as it may be necessary to conceal the inner workings of the security device in order to protect the device from tampering or reverse-engineering.

USB keys and similar portable computer devices often include a LED or other light source at its end opposite the portion that plugs into the computer port. The light source illuminates, for example, when the device is plugged into the computer port and is operational, to provide the user with a visual indication that the device is working. In known devices, the LED or other light source emits light through an aperture located in the opaque housing proximate the light source. The aperture is typically kept to a relatively small size in order to conceal the inner workings of the device. This configuration often makes it difficult or impossible to see the light emitting from the light source except when the device is viewed from a very narrow range of viewing angles (e.g., directly at the end of the device containing the light source).

What is needed then, is an improved housing for a portable computer device that overcomes the shortcomings of conventional solutions.

### BRIEF SUMMARY OF THE INVENTION

According to one exemplary embodiment of the invention, a portable computer device comprises a circuit board; a connector in communication with the circuit board, the connector adapted for insertion into a computer port; a light source associated with the circuit board; and a housing encasing at least the circuit board and the light source, the housing comprising a substantially opaque body portion and a substantially transparent or translucent lens portion, the lens portion located proximate the light source.

According to another exemplary embodiment of the invention, a housing for a portable computer device comprises a shell including a connector portion adapted for insertion into a computer port; a substantially opaque plastic body portion encasing at least a portion of the shell; and a substantially transparent or translucent plastic lens portion co-molded with the body portion.

According to yet another exemplary embodiment of the invention, a method of forming a housing for a portable computer device comprises injection molding a first portion of the housing in a first injection mold cavity; transferring the first portion of the housing to a second injection mold cavity; and injection molding a second portion of the housing in the second injection mold cavity, whereby the first portion and the second portion join together.

Further objectives and advantages, as well as the structure and function of preferred embodiments will become apparent from a consideration of the description, drawings, and examples.

### BRIEF DESCRIPTION OF THE DRAWINGS

The foregoing and other features and advantages of the invention will be apparent from the following, more particular description of a preferred embodiment of the invention, as illustrated in the accompanying drawings wherein like reference numbers generally indicate identical, functionally similar, and/or structurally similar elements.

FIG. 1 is a perspective view of an exemplary portable computer device according to the present invention;

FIG. 2 is a perspective view of an exemplary body portion of a housing according to the present invention;

FIG. 3 is a perspective view of an exemplary lens portion of a housing according to the present invention;

FIG. 4 is a top view of the exemplary portable computer device of FIG. 1;

FIG. 5 is cross-sectional view of the exemplary portable computer device of FIG. 4, taken along line V-V;

FIG. 6 is a perspective view of an exemplary connector portion according to the present invention;

FIG. 7 is a top cross-sectional view of the exemplary connector portion of FIG. 6;

FIG. 8 is an end view of the exemplary connector portion of FIG. 6; and

FIG. 9 is a flow diagram illustrating an exemplary embodiment of forming a housing for a portable computer device according to the present invention.

### DETAILED DESCRIPTION OF THE INVENTION

Embodiments of the invention are discussed in detail below. In describing embodiments, specific terminology is employed for the sake of clarity. However, the invention is not intended to be limited to the specific terminology so selected. While specific exemplary embodiments are discussed, it should be understood that this is done for illustration purposes only. A person skilled in the relevant art will recognize that other components and configurations can be used without departing from the spirit and scope of the invention. All references cited herein are incorporated by reference as if each had been individually incorporated.

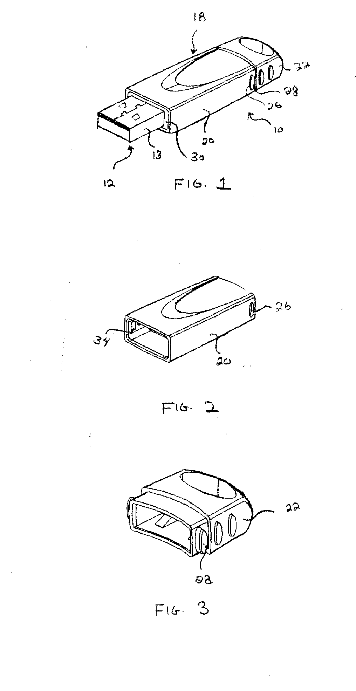

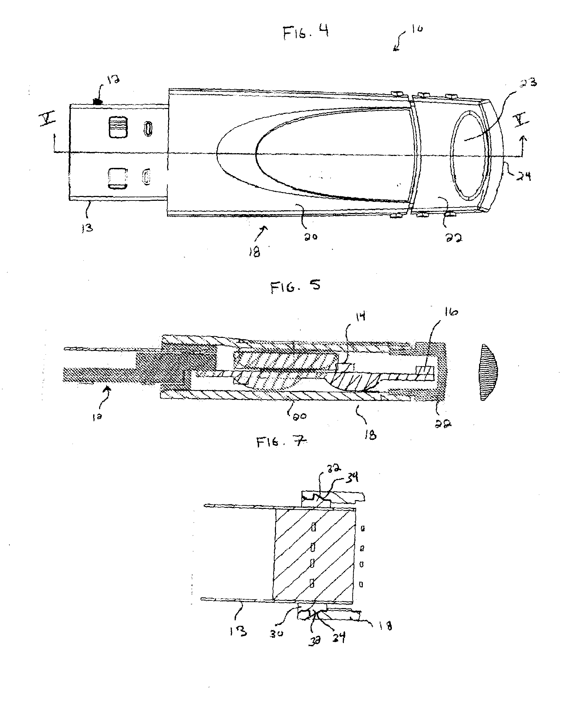

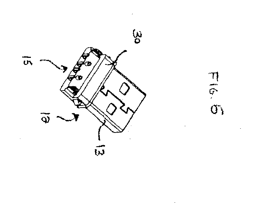

Referring to FIGS. 1 and 4, an exemplary embodiment of a portable computer device 10 according to the present invention is shown. Portable computer device 10 can include a connector 12 adapted to interface the portable computer device 10 with a computer port. Referring in particular to FIG. 6, connector 12 can be a USB-type connector. However, according to alternative embodiments, the connector can be a parallel port connector, a serial port connector, a RS-232 connector, or any other type of connector known in the art. Still referring to FIG. 6, connector 12 can include a metallic shell portion 13 having a shape that substantially compliments the corresponding computer port. Connector 12 can also include leads, conductors, or other devices, denoted generally as 15, that can interface the connector 12 with a circuit board 14 or other components.

Referring to the cross-sectional view of FIG. 5, portable computer device 10 can include a circuit board 14 in communication with the connector 12. The circuit board 14 can include any number of known computer devices, such as memory, processor(s), power supplies, etc., further details of which are known to one of ordinary skill in the art and not provided in further detail herein. According to one exemplary embodiment of the invention, portable computer device 10 can be a portable data storage device. According to another exemplary embodiment of the invention, portable computer device 10 can be a security key. One of ordinary skill in the art will know that device 10 can be any number of different portable computer components.

Still referring to the cross-sectional view of FIG. 5, portable computer device 10 can include a light source 16 (shown schematically) that is associated with the circuit board. Light source 16, for example, a light emitting diode (LED), can be adapted to illuminate when the connector 12 is successfully inserted into a computer port (not shown) and the portable computer device 10 is operational.

Referring again to FIGS. 1 and 4, portable computer device 10 can also include a housing 18 that can encase the circuit board 14 and its associated components, the LED 16, and a portion of the connector 12. Referring to FIGS. 2 and 3, housing 18 can include a substantially opaque, plastic body portion 20, and a substantially transparent or translucent plastic lens portion 22. For illustrative purposes, the body portion 20 and the lens portion 22 are shown separately in FIGS. 2 and 3, however, according to an exemplary embodiment of the present invention, these parts are integral with one another, for example, co-molded with one another during manufacturing. The lens portion 22 can include a through bore 23 adapted to receive a key ring or other device that may be used to carry the device 10.

With reference to FIGS. 4 and 5, the substantially opaque body portion 22 can cover substantially all of the internal working components of the portable computer device 10 (e.g., processors, memories, other storage devices, etc.) and can conceal them from view by the user, thereby enhancing the security of the device 10. The substantially transparent or translucent lens portion 22, however, can be located proximate the light source 16, so that light emitted from the light source 16 shines through and illuminates all or a portion of the lens portion 22. Thus, based on the size and/or shape of the lens portion 22, the light source 16 can provide a visual indicator that is easily viewed from multiple angles with respect to the portable computer device 10. Referring to FIGS. 4 and 5, the housing can include a proximal end 24 located substantially opposite the connector 12, and the lens portion 22 can be located at the proximal end 24 of the device 10, however, other configurations are possible.

As mentioned above, the body portion 20 and lens portion 22 can be integral with one another, for example, co-molded with one another, further details of which are provided below. The body portion 20 and lens portion 22 can also positively engage one another, for example, by forming interlocking portions on these two parts when co-molding them. Referring to FIGS. 1-3, the body portion 20 can include an aperture 26, or a recess or other indented feature. The lens portion 22 can include a mating protrusion 28 or similar projecting feature. During the molding process, for example, these parts can be formed to engage or interlock with one another, resulting in positive engagement between the body portion 20 and the lens portion 22, thereby strengthening the housing 18. One of ordinary skill in the art will recognize that the recess 26 can alternatively be located on the lens portion 22 with the protrusion 28 located on the body portion 20. The unitary, co-molded construction of the body portion 20 and the lens portion 22 can result in a housing 18 that is significantly stronger than conventional housings that are molded as two separate parts and subsequently fastened together by adhesive, snap engagement, or other fastening techniques. This increased strength increases the security provided by the housing 18 against tampering.

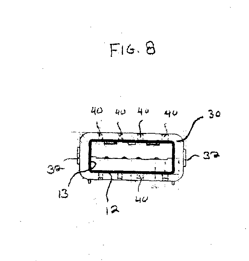

Referring to FIGS. 1, 5, and 8, a collar 30 can interconnect the housing 18 and the connector 12. For example, the collar 30 can comprise a layer of plastic that is molded onto all or a portion of the metallic shell portion 13. The collar 30 can have external geometry that is substantially complimentary to the internal geometry of the mating portion of the housing 18. The collar 30 can include ramped projections 32 (shown in FIG. 8) and the mating part of the housing 18 can include mating recesses 34 (one of which is shown in FIG. 2). The ramped projections 32 can be adapted to snap into place in the recesses 34 (see FIG. 7) in order to securely connect the housing 18 to the shell 13. Once snapped together, the projections 32 and mating recesses 34 provide a strong, substantially permanent connection between the housing 18 and connector 12 that is difficult to undo. One of ordinary skill in the art will know that the projections 32 can alternatively be located on housing 18 with the recesses 34 located on the collar 30.

Referring to FIG. 8, a plurality of barbs 40 can project outwardly from the metallic shell 13 of connector 12. The barbs 40 can comprise, for example, integral pieces of metal that are stamped into projections during formation of the shell 13. The barbs 40 project from the shell 13 and into the collar 30, thereby reinforcing the interconnection between these two components. For example, the barbs 40 can form a positive, form-fit engagement with the collar 30 when the collar 40 is molded around the shell 13.

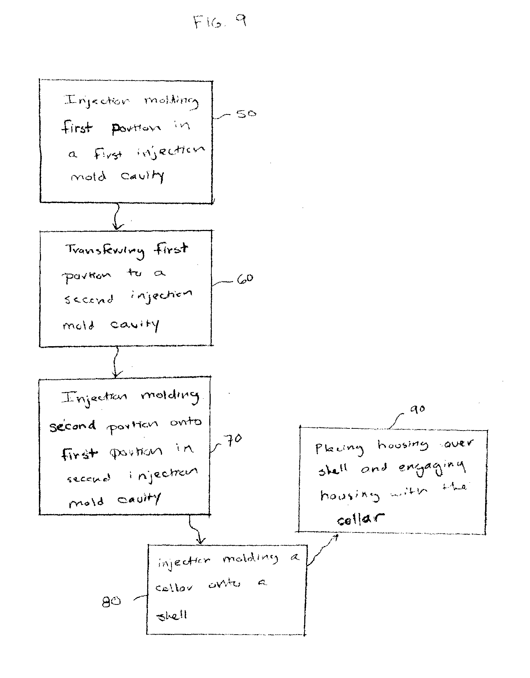

FIG. 9 is a flow diagram illustrating an exemplary embodiment of forming a housing for a portable computer device according to the present invention. Specifically, the method comprises co-molding the body portion 20 and the lens portion 22 in a "two-shot" injection molding process, with the body portion 20 being molded of an opaque plastic material, and with the lens portion 22 being molded of a substantially transparent or translucent plastic material.

According to an exemplary embodiment of the invention, in a molding step 50, a first portion of the housing can be injection molded in a first injection mold cavity. For example, the body portion 20 can be injection molded in an injection mold cavity (e.g., an injection mold cavity that has substantially the inverse geometry of the body portion 20 depicted in FIG. 2). The body portion 20 can be molded from any opaque thermoplastic material known in the art, such as Polycarbonate or Polycarbonate ABS blends.

Next, in a transferring step 60, the first portion can be transferred to a second injection mold cavity. This transferring step 60 can be carried out manually (*e.g*., by hand), or alternatively, using various types of automated or robotic equipment known in the art.

The method can further include a second molding step 70, in which a second portion of the housing, for example, the lens portion 22, can be injection molded in the second injection mold cavity. The second injection mold cavity can have substantially the inverse geometry of the completed housing 18 (*i.e*. body portion 20 plus lens portion 22). This second molding step 70 can result in an unitary or integral, co-molded housing 18 comprising the opaque body portion 20 and the substantially transparent or translucent lens portion 22. The lens portion 22 can be molded from any substantially transparent or translucent thermoplastic material known in the art, such as Polycarbonate or Polycarbonate ABS blends. According to another exemplary embodiment, the lens portion 22 can be injection molded in the first molding step 50, and the body portion 20 can be molded in the second injection molding step 70.

According to an exemplary embodiment of the invention, the thermoplastics for the first portion of the housing and the second portion of the housing can similar melt temperatures, so that the first portion softens slightly during the second molding step 70, thereby enhancing the bond between the first portion and the second portion.

According to an exemplary embodiment of the invention, the second molding step 70 can occur prior to, or at the latest, just shortly after the first portion of the housing has completely hardened. Alternatively, the second molding step can occur after the first portion of the housing has completely hardened.

According to an exemplary embodiment, one of the first and second molding steps 50, 70 can comprise molding a recess into one of the body portions (*e.g*., the aperture 26 in body portion 20) and the other of the molding steps 50, 70 can comprise molding a protrusion into the recess (e.g., the protrusion 28 on lens portion 22).

Referring again to FIG. 9, the method can also comprise the step 80 of injection molding a collar portion onto a metallic shell portion. See, for example, the collar portion 30 molded onto shell 13, shown in FIG. 8. For example, the shell 13 can be placed in a mold cavity having substantially the same geometry as the shell 13 plus the collar portion, and the collar portion 30 can be injection molded into the mold space between the shell 13 and the mold cavity. The method can further comprise forming integral barbs on the shell 13 (e.g., by stamping prior to the injection molding step) and injection molding the collar portion 30 onto the barbs. This can reinforce the connection between the shell 13 and the collar portion.

The method can further comprise the step 90 of placing the housing onto the shell 13 and interconnecting the housing 18 with the collar portion 30, for example, by a snap connection between the projection 32 and corresponding recesses 34 in FIG. 7, such as, for example, a "jam-pot" connection. Additionally or alternatively, the housing 18 and collar 30 can be permanently glued or bonded together, for example, in high security applications.

The embodiments illustrated and discussed in this specification are intended only to teach those skilled in the art the best way known to the inventors to make and use the invention. For example, the above-described method of forming the housing 18 can alternatively be performed by injecting two different types of plastic in a single injection mold cavity, instead of two different cavities as described above. Thus, nothing in this specification should be considered as limiting the scope of the present invention. All examples presented are representative and non-limiting. The above-described embodiments of the invention may be modified or varied, without departing from the invention, as appreciated by those skilled in the art in light of the above teachings. It is therefore to be understood that, within the scope of the claims and their equivalents, the invention may be practiced otherwise than as specifically described.

## Claims

1. A portable computer device, comprising:
a circuit board;
a connector in communication with the circuit board, the connector adapted for insertion into a computer port;
a light source associated with the circuit board; and
a housing encasing at least the circuit board and the light source, the housing comprising a substantially opaque body portion and a substantially transparent or translucent lens portion, the lens portion located proximate the light source.

2. The portable computer device of claim 1, wherein the housing includes a proximal end located substantially opposite the connector, and the lens portion is located at the proximal end.

3. The portable computer device of claim 1, wherein the body portion conceals substantially all of the circuit board.

4. The portable computer device of claim 1, wherein the light source is adapted to emit light through the lens portion when the connector is connected to a computer port and the portable computer device is operational.

5. The portable computer device of claim 1, wherein the light source is a light emitting diode.

6. The portable computer device of claim 1, wherein the body portion and the lens portion are co-molded from plastic.

7. The portable computer device of claim 1, wherein the portable computer device is a USB key.

8. A housing for a portable computer device, comprising:
a shell including a connector portion adapted for insertion into a computer port;
a substantially opaque plastic body portion encasing at least a portion of the shell; and
a substantially transparent or translucent plastic lens portion co-molded with the body portion.

9. The housing of claim 8, wherein the lens portion positively engages the body portion.

10. The housing of claim 9, further comprising at least one protrusion on the lens portion and at least one cooperating recess on the body portion, wherein the protrusion extends through the recess.

11. The housing of claim 8, further comprising a collar interconnecting the shell and the housing.

12. The housing of claim 11, wherein the collar is molded onto the shell.

13. The housing of claim 12, further comprising integral barbs extending outwardly from the shell and into the collar, wherein the barbs engage the collar.

14. The housing of claim 13, wherein the barbs are stamped onto the shell.

15. A method of forming a housing for a portable computer device, comprising:
(a) injection molding a first portion of the housing in a first injection mold cavity;
(b) transferring the first portion of the housing to a second injection mold cavity; and
(c) injection molding a second portion of the housing in the second injection mold cavity, whereby the first portion and the second portion join together.

16. The method of claim 15, wherein the step (c) occurs prior to complete hardening of the first portion of the housing.

17. The method of claim 15, wherein the step (c) occurs after complete hardening of the first portion of the housing.

18. The method of claim 15, wherein the first portion is a substantially opaque body portion.

19. The method of claim 15, wherein the first portion is a substantially transparent or translucent lens portion.

20. The method of claim 15, wherein the second portion is a substantially transparent or translucent lens portion.

21. The method of claim 15, wherein the second portion is a substantially opaque body portion.

22. The method of claim 15, wherein the step (b) is carried out by hand.

23. The method of claim 15, wherein the step (b) is automated.

24. The method of claim 15, wherein the step (a) comprises molding a recess in the first portion, and the step (c) comprises molding a protrusion in the second portion that extends into the recess.

25. The method of claim 15, further comprising the steps of:
(d) injection molding a collar onto a shell; and
(e) placing the housing over the shell and engaging a portion of the housing with the collar.

26. The method of claim 25, further comprising the step of forming integral, outwardly-extending barbs on the shell prior to the step (d), wherein the step (d) comprises injection molding the collar over the barbs.
